# EUROPEAN PATENT APPLICATION

(11) **EP 2 716 986 A1**
(43) Date of publication of application: **09.04.2014**
(21) Application number: 11746430.5
(22) Date of filing: 31.07.2011
(51) Int. Cl.: F24F 7/04, F24F 12/00

(54) **AIR HEAT EXCHANGE DEVICE AND MANUFACTURING METHOD THEREOF, AND INTEGRATIVE AIR HEAT EXCHANGE AIR-CONDITIONING DEVICE**

(30) Priority: 30.05.2011 CN 201110142331
(71) Applicant: Tonlier Energy Technology (Beijing) Co., Ltd., Beijing 101111 (CN)
(72) Inventor: WANG, Zhen, Daxing Beijing 101111 (CN); LIU, Dingqing, Daxing Beijing 101111 (CN)
(74) Representative: Jeannet, Olivier
(86) International application number: PCT/CN2011/077837
(87) International publication number: WO 2012/162938

(57) **Abstract**

An air heat exchanging device is provided, which includes an upper flow divider, a heat exchanging core, and a lower flow divider. An indoor wind channel and an outdoor wind channel are disposed in the upper flow divider, the heat exchanging core, and the lower flow divider respectively, and an air inducing pipe communicating with indoor heat generating equipment is disposed at an air inlet of the indoor wind channel. An integrated heat-exchanging air-conditioning device including the air heat exchanging device is also provided, in which an air conditioning evaporator is disposed at one side of the indoor wind channel near the air inducing pipe. Therefore, the air heat exchanging device and the integrated heat-exchanging air-conditioning device perform direct heat exchange with high-temperature air generated by the indoor equipment, thereby greatly increasing the energy efficiency ratio of the air heat exchanging device and the integrated heat-exchanging air-conditioning device, further saving the energy and reducing consumption, enlarging the climate application range of the air heat exchanging device and integrated heat-exchanging air-conditioning device, and preventing air at hot spots in the machine room from spreading. A manufacturing method of an air heat exchanging device having an air inducing pipe is further provided.

## Description

### BACKGROUND OF THE INVENTION

### Field of Invention

The present invention relates to the field of heat exchanging equipment, in particular, to an air heat exchanging device having an air inducing pipe, a manufacturing method thereof, and an integrated heat-exchanging air-conditioning device.

### Related Art

Air conditioning equipment is applicable to various places such as machine rooms of communication base stations, other machine rooms, office buildings, hotels, cinemas, and families to condition the temperature of the air, which brings a huge pressure on energy resource. Therefore, how to reduce the energy consumption of the air conditioning equipment has become a common issue encountered by manufacturers and users of the air conditioning equipment.

In the operation of the air conditioning equipment, major energy consumption occurs at the works of cooling or heating. Therefore, the key of reducing the energy consumption of the air conditioning equipment is avoiding using the cooling or heating function as much as possible. Currently, air heat exchanging devices using a nature abundant cool source of a large difference between ambient temperatures in and out of the room are widely used, so as to perform isolated heat exchange on the outdoor air and the indoor air, which effectively reduces the working time for the cooling function or heating function of the air conditioning equipment, thereby effectively reducing the energy consumption. It can be considered that, the air heat exchanging device and the integrated heat-exchanging air-conditioning device may also be used separately without depending on the air conditioning equipment, so as to condition the indoor temperature to a certain extent. The integrated heat-exchanging air-conditioner may also be used separately to improve the temperature conditioning in the room.

The conventional air heat exchanger or integrated heat-exchanging air-conditioner mainly includes an upper flow divider, a heat exchanging core and a lower flow divider. An air outlet of the upper flow divider and an air outlet of the lower flow divider are respectively connected to a fan. An indoor wind channel and an outdoor wind channel separated from each other are disposed in the upper flow divider, the heat exchanging core and the lower flow divider respectively. The indoor wind channels and the outdoor wind channels of the upper flow divider, the heat exchanging core and the lower flow divider communicate with each other to constitute an indoor air flow channel and an outdoor air flow channel. The indoor air flow and the outdoor air flow having a temperature difference may perform heat exchange when flowing through the indoor wind channel and the outdoor wind channel separated from each other in the heat exchanging core in opposite directions. However, the conventional air heat exchanger or integrated heat-exchanging air-conditioner has the following defects.
1. In the conventional air heat exchanging device and integrated heat-exchanging air-conditioning device, the air inlet of the indoor wind channel communicates with the machine room of the communication base station, a great amount of heat is generated by the equipment in the machine room of the communication base station, and the heat is collected by the air heat exchanging device and the integrated heat-exchanging air-conditioning device to enter the indoor wind channel and perform heat exchange with nature cool air in the outdoor wind channel, in this way, the air heat exchanging device and the integrated heat-exchanging air-conditioning device cannot directly perform heat exchange with the hot air generated by the equipment, and therefore, the performance of the devices cannot be fully used, so as to be adverse to energy saving and power consumption reduction.
2. The hot air of the indoor heat generating equipment is first spread in the machine room, the spread hot air has a relatively low temperature, and if the outdoor temperature is high, for example, more than 30°C in summer of south China, the air heat exchanging device and the integrated heat-exchanging air-conditioning device cannot reduce the temperate in the machine room, thereby greatly limiting the applicable climate range of the air heat exchanging device and the integrated heat-exchanging air-conditioning device.
3. After the hot air is spread in the machine room, it is hard for the air heat exchanging device and the integrated heat-exchanging air-conditioning device to collect and process the hot air.
4. The technical development of the conventional air heat exchanging device and integrated heat-exchanging air-conditioning device emphasizes increasing the energy efficiency ratio under fixed working condition, while neglecting the research on increasing the energy efficiency ratio by changing the working condition of the spot using the devices, thereby being incapable of solving the tropic applicability of the air heat exchanging device and the integrated heat-exchanging air-conditioning device.

### SUMMARY OF THE INVENTION

The present invention is directed to an air heat exchanging device, capable of effectively increasing energy efficiency ratio, saving energy, and being applicable to a wide climate range.

The present invention is further directed to a manufacturing method of an air heat exchanging device, capable of effectively increasing energy efficiency ratio, saving energy, and being applicable to a wide climate range.

The present invention is further directed to an integrated heat-exchanging air-conditioning device, in which the integrated device combines an air heat exchanging device and an air conditioning evaporator, thereby being capable of effectively increasing energy efficiency ratio, saving energy, and being applicable to a wide climate range.

In order to solve the above problems, the present invention provides an air heat exchanging device, which includes an upper flow divider, a heat exchanging core, and a lower flow divider. An air outlet of the upper flow divider and an air outlet of the lower flow divider are respectively connected to a fan, an indoor wind channel and an outdoor wind channel separated from each other are disposed in the upper flow divider, the heat exchanging core, and the lower flow divider respectively, and an air inducing pipe communicating with indoor heat generating equipment is disposed at an air inlet of the indoor wind channel.

In the air heat exchanging device, one port of the air inducing pipe is disposed above the indoor heat generating equipment, and the other port of the air inducing pipe is disposed above the air inlet of the indoor wind channel or connected to the air inlet of the indoor wind channel.

In the air heat exchanging device, the air inducing pipe is constituted by a plurality of air inducing branch pipes disposed in parallel, and each air inducing branch pipe has one port disposed above the indoor heat generating equipment, and the other port disposed above the air inlet of the indoor wind channel or connected to the air inlet of the indoor wind channel.

In the air heat exchanging device an air inducing fan is disposed between the air inlet of the indoor wind channel and the air inducing pipe.

In the air heat exchanging device, the air inducing fan and the air inducing pipe are seal connected, and the air inducing fan and the air inlet of the indoor wind channel are also seal connected.

In the air heat exchanging device, the air inlet of the indoor wind channel is disposed at a top of the air heat exchanging device, and an air outlet of the indoor wind channel is disposed at a lower part of the air heat exchanging device.

In the air heat exchanging device, the air inducing pipe is a flame-retarded hose.

The present invention further provides a manufacturing method of an air heat exchanging device, which includes the following steps.

An air inducing pipe is mounted at an air inlet of an indoor wind channel of the air heat exchanging device.

One end of the air inducing pipe is disposed above the air inlet of the indoor wind channel, and the other end of the air inducing pipe communicates with indoor heat generating equipment.

The manufacturing of the air heat exchanging device further includes disposing an air inducing fan, and the air inducing fan is seal connected between the air inlet of the indoor wind channel and the air inducing pipe.

The present invention further provides an integrated heat-exchanging air-conditioning device, which includes the air heat exchanging device as described above, in which an air conditioning evaporator is disposed at one side of an indoor wind channel of the air heat exchanging device near the air inducing pipe.

According to the above solutions, the present invention has significant advantages as compared with the prior art.
1. In the present invention, an air inducing pipe is disposed at an air inlet of an indoor wind channel of the air heat exchanging device and the integrated heat-exchanging air-conditioning device, the air inducing pipe extends to the air heat exchanging device and the integrated heat-exchanging air-conditioning device and communicates with a hot air outlet of heat generating equipment, so that the hot air is directly guided into the indoor wind channel of the air heat exchanging device and the integrated heat-exchanging air-conditioning device through the air inducing pipe. Therefore, the air heat exchanging device and the integrated heat-exchanging air-conditioning device perform direct heat exchange with high-temperature air generated by the indoor equipment, thereby greatly increasing the energy efficiency ratio of the air heat exchanging device and the integrated heat-exchanging air-conditioning device, further saving the energy and reducing consumption, enlarging the climate application range of the air heat exchanging device and the integrated heat-exchanging air-conditioning device, and preventing air at hot spots in the machine room from spreading.
2. In the present invention, air enters a room from a top of the room and leaves the room from a bottom of the room, hot air enters the air heat exchanging device and the integrated heat-exchanging air-conditioning device from an upper portion, and cool air is blown out from an indoor air outlet at a lower portion, which facilitates the circulation of the indoor air, and therefore, the indoor air is cooled.

### BRIEF DESCRIPTION OF THE DRAWINGS

The present invention will become more fully understood from the detailed description given herein below for illustration only, and thus are not limitative of the present invention, and wherein:
FIG. 1 is a schematic structural view of a first embodiment of an air heat exchanging device according to the present invention;
FIG. 2 is a schematic structural view of a second embodiment of an air heat exchanging device according to the present invention;
FIG. 3 is a schematic structural view of a first embodiment of an integrated heat-exchanging air-conditioning device according to the present invention; and
FIG. 4 is a schematic structural view of a second embodiment of an integrated heat-exchanging air-conditioning device according to the present invention.

1-upper flow divider; 2-heat exchanging core; 3-lower flow divider; 4-fan; 5-indoor wind channel; 6-outdoor wind channel; 7-indoor heat generating equipment; 8-air inducing pipe; 81-air inducing branch pipe; 9-air inducing fan; 10-air heat exchanging device; 11-air conditioning evaporator; 12-integrated heat-exchanging air-conditioning device.

### DETAILED DESCRIPTION OF THE INVENTION

### First embodiment of an air heat exchanging device:

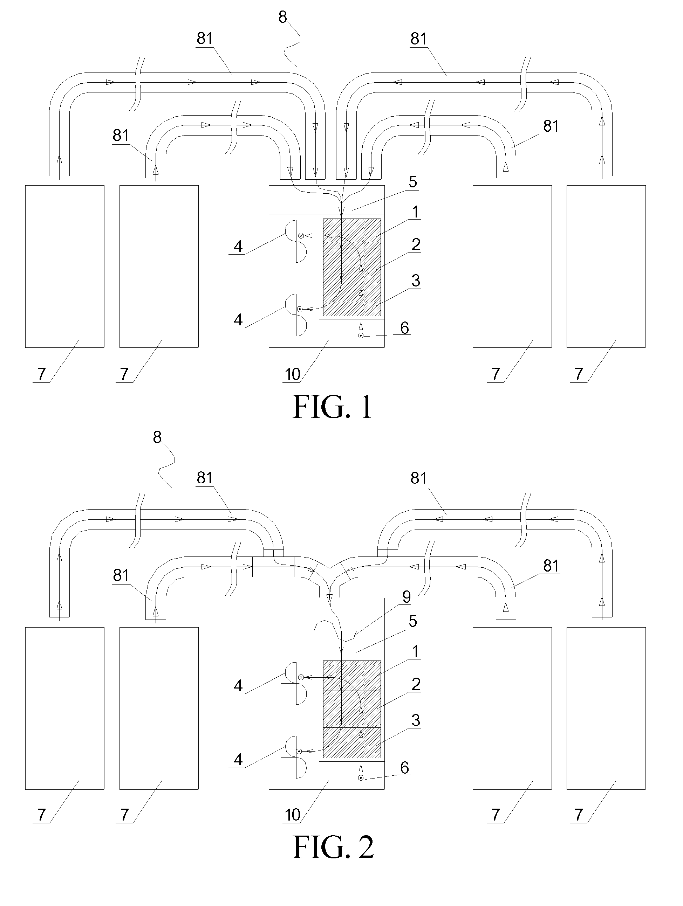

Referring to FIG. 1, a schematic structural view of the first embodiment of the air heat exchanging device according to the present invention is shown. As shown in the figure, the air heat exchanging device 10 provided in the present invention includes an upper flow divider 1, a heat exchanging core 2, and a lower flow divider 3. An air outlet of the upper flow divider 1 and an air outlet of the lower flow divider 2 are respectively connected to a fan 4, and an indoor wind channel 5 and an outdoor wind channel 6 separated from each other are disposed in the upper flow divider 1, the heat exchanging core 2, and the lower flow divider 3 respectively. Hot air of indoor heat generating equipment 7 enters the air heat exchanging device through the indoor wind channel 5, outdoor cool air also enters the air heat exchanging device through the outdoor wind channel 6, and the hot air and the cool air perform heat exchange at the heat exchanging core 2. In the present invention, in order that the air heat exchanging device can perform heat exchange directly with the indoor heat generating equipment 7, an air inducing pipe 8 is disposed at an air inlet of the indoor wind channel 5, and the air inducing pipe 8 has one port communicating with the indoor heat generating equipment 7, and the other port communicating with the air inlet of the indoor wind channel 5. Therefore, the air heat exchanging device may perform direct heat exchange with high-temperature air generated by the indoor equipment, thereby greatly increasing the energy efficiency ratio of the air heat exchanging device, further saving the energy and reducing consumption, enlarging the climate application range of the air heat exchanging device, and preventing air at hot spots in the machine room from spreading.

Further, the air inducing pipe 8 has one port disposed above the indoor heat generating equipment 7, and the other port disposed above the air inlet of the indoor wind channel 5 or connected to the air inlet of the indoor wind channel, thereby facilitating the connection and convey of hot air of the indoor heat generating equipment 7.

In this embodiment, as shown in FIG. 1, in order to directly perform heat exchange with a plurality of indoor heat generating equipment 7, the air inducing pipe 8 is constituted by a plurality of air inducing branch pipes 81 disposed in parallel, and each air inducing branch pipe 81 has one port disposed above the indoor heat generating equipment 7, and the other port disposed above the air inlet of the indoor wind channel 5 or connected to the air inlet of the indoor wind channel 5. The number of the air inducing branch pipes 81 depends on the heat generated by the indoor heat generating equipment and the number of the indoor equipment, and the air inducing branch pipes 81 are mounted flexibly according to the situation on site, as long as the heat generated by the heat generating equipment can be conveyed to the air heat exchanging device as much as possible, so as to cool the indoor environment to the maximum extent, thereby effectively saving energy.

Further, as shown in FIG. 1, the air inlet of the indoor wind channel 5 is disposed at a top of the air heat exchanging device 10, and an air outlet of the indoor wind channel 5 is disposed at a lower part of the air heat exchanging device 10. In this way, as the air intake is disposed at the top of the room and the air outtake is disposed at the lower part of the room, the hot air enters from an upper part of the air heat exchanging device 10, and the cool air is blown out from the air outlet at the lower part of the room, thereby facilitating the circulation of the indoor air, and cooling the indoor air accordingly.

In the present invention, the air inducing pipe 8 is a flame-retarded hose. The shape of the air inducing pipe 8 may be designed as a straight line shape, a bent shape, or other suitable shape as desired according to actual situation.

The high-efficient air heat exchanging device of the present invention includes members such as an upper flow divider, a heat exchanging core, a lower flow divider, an indoor fan, and an outdoor fan. Under the driving of the two fans, two air flows indoors and outdoors perform heat exchange in the heat exchanging core, so as to bring the heat in the hot air in the room to the outside, and cool the indoor hot air. When the temperature difference between the indoor air and the outdoor air is small, the heat exchanging effect of the air heat exchanging device is greatly reduced, and at this time, an air inducing pipe is added in the present invention. The hot air above the indoor heat generating equipment is directly guided into the air heat exchanging device through the air inducing pipe, and therefore, the temperature of the indoor air guided into the heat exchanging core is much larger than the average temperature in the room, which equals to greatly increasing the temperature difference between the two air flows in the heat exchanging core, thereby increasing the heat exchanging capacity of the core, greatly improving the heat exchanging efficiency of the heat exchanging core, and enlarging the application range of the heat exchanging device. Therefore, the present invention realizes effects of greatly increasing energy efficiency ratio of the air heat exchanging, further saving the energy and reducing the consumption, enlarging the climate application range of the air heat exchanging device, and preventing the hot air from spreading.

### Second embodiment of an air heat exchanging device:

Referring to FIG. 2, a schematic structural view of the second embodiment of the air heat exchanging device according to the present invention is shown. In this embodiment, members the same as those in the first embodiment are labeled by the same reference numerals.

As shown in FIG. 2, a difference between this embodiment and the air heat exchanging device of the firs embodiment lies in that, an air inducing fan 9 is connected between the air inlet of the indoor wind channel 5 and the air inducing pipe 8. The air inducing fan 9 may be added selectively according to different lengths of paths of the air inducing pipe 8 for guiding hot air, thereby enhancing the intensity of the guiding wind, and ensuring the guiding of the hot air.

The air inducing fan 9 and the air inducing pipe 8 are seal connected, and the air inducing fan 9 and the air inlet of the indoor wind channel 5 are also seal connected through, for example, flange connection or clamp connection, so as to ensure that the hot air is guided into the indoor wind channel 5. The present invention may also adopt other well-known seal connection manners, as long as the air tightness between the air inducing fan 9 and the air inducing pipe 8 and between the air inducing fan 9 and the air inlet of the indoor wind channel 5 is ensured.

When the air heat exchanging device is close to the heat source in the machine room, hot air is guided in a manner as shown in FIG. 1, in which, one end of the air inducing pipe is disposed above the heat source, the other end of the air inducing pipe is disposed above the indoor air inlet of the air heat exchanging device, the heat generated by the heat source enters the heat exchanging device through the air inducing pipe under the function of the fan of the air heat exchanging device, and at this time, the two ends of the air inducing pipe do not need to be sealed. When the air heat exchanging device is away from the heat source in the machine room, hot air is guided in a manner as shown in FIG. 2, in which, an air inducing fan is added above the indoor air inlet of the air heat exchanging device, one end of the air inducing pipe is disposed above the heat source, the other end of the air inducing pipe communicates with an air inlet of the air inducing fan, and if a plurality of heat sources exists in the room, a tee connection is required to be added above the air inducing fan to communicate the heat sources, thereby ensuring that the heat generated by the heat sources all enters the air heat exchanging device directly. At this time, the air inducing pipe and the air inducing fan need to be seal connected, and the air inducing fan and the heat exchanging device need to be seal connected. Seal connection is not required between the air inducing pipe and the heat sources.

Other structures, working principles and effects of this embodiment are the same as those of the air heat exchanging device in the first embodiment, and are not repeated herein.

Further, the present invention provides a manufacturing method of an air heat exchanging device, which includes the following step.

An air inducing pipe is mounted at an air inlet of an indoor wind channel of the air heat exchanging device.

The air inducing pipe has one end disposed above the air inlet of the indoor wind channel, and the other end communicating with the indoor heat generating equipment.

The air inducing pipe of the present invention may be mounted in two manners. In the first manner, as shown in FIG. 1, the air inducing pipe is used to directly communicate the air heat exchanging device and the indoor heat generating equipment, the air inducing pipe only needs to have two ends thereof suspending above the air heat exchanging device and the heat generating equipment, and no seal connection is required. This manner is applicable to the situation that the air inducing pipe is not long. In the second manner, as shown in FIG. 2, an air inducing fan is added above the air heat exchanging device, and the air inducing fan cooperates with the air inducing pipe to guide the hot air above the indoor heat generating equipment into the air heat exchanging device, and at this time, the seal connection is required at the air inducing fan side, that is, the air inducing fan is seal connected between the air inlet of the indoor wind channel and the air inducing pipe, and the seal connection is not required at the heat generating equipment side. This manner is applicable to the situation that the air inducing pipe is long. The air inducing pipe of the present invention can be mounted simply, operated flexibly, and thus being implemented easily.

### First embodiment of an integrated heat-exchanging air-conditioning device:

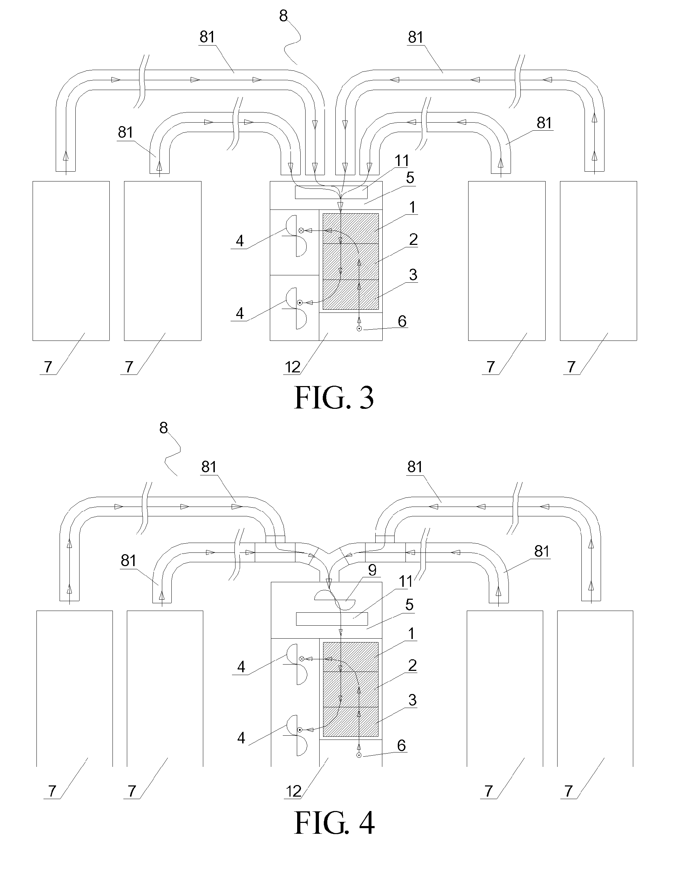

Referring to FIG. 3, a schematic structural view of the first embodiment of the integrated heat-exchanging air-conditioning device according to the present invention is shown. In this embodiment, members the same as those in the first embodiment of the air heat exchanging device are labeled by the same reference numerals.

The present invention further provides an integrated heat-exchanging air-conditioning device12, which includes the air heat exchanging device 10, in which an air conditioning evaporator 11 is disposed at one side of the indoor wind channel 5 of the air heat exchanging device 10 near the air inducing pipe 8. In this way, the air heat exchanging device and the air conditioning evaporator are combined to form an integrated structure, and the integrated heat-exchanging air-conditioner may be used separately to improve the temperature conditioning in the room.

Other structures, working principles and effects of this embodiment are the same as those in the first embodiment of the air heat exchanging device, and are not repeated herein.

### Second embodiment of an integrated heat-exchanging air-conditioning device:

Referring to FIG. 4, a schematic structural view of the second embodiment of the integrated air conditioner according to the present invention is shown. In this embodiment, members the same as those in the second embodiment of the air heat exchanging device are labeled by the same reference numerals.

As shown in FIG. 4, a difference between this embodiment and the first embodiment of the integrated heat-exchanging air-conditioning device lies in that, an air inducing fan 9 is connected between the air inlet of the indoor wind channel 5 and the air inducing pipe 8. The air inducing fan 9 may be added selectively according to different lengths of paths of the air inducing pipe 8 for guiding hot air, thereby enhancing the intensity of the guiding wind, and ensuring the guiding of the hot air.

Other structures, working principles and effects of this embodiment are the same as those in the first embodiment of the integrated heat-exchanging air-conditioning device, and are not repeated herein.

Preferred embodiments of the present invention are described above, which are not intended to limit the present invention. Those skilled in the art can make various changes and modifications on the present invention, and any modifications, equivalent replacements, and improvements without departing from the spirit of the present invention should fall within the protection scope of the present invention.

## Claims

1. An air heat exchanging device, comprising an upper flow divider, a heat exchanging core, and a lower flow divider, an air outlet of the upper flow divider and an air outlet of the lower flow divider being respectively connected to a fan, and an indoor wind channel and an outdoor wind channel separated from each other being disposed in the upper flow divider, the heat exchanging core and the lower flow divider respectively, wherein:
an air inducing pipe communicating with indoor heat generating equipment is disposed at an air inlet of the indoor wind channel, and the air inducing pipe is constituted by a plurality of air inducing branch pipes disposed in parallel;
each air inducing branch pipe has one port disposed above the indoor heat generating equipment, and the other port disposed above the air inlet of the indoor wind channel or connected to the air inlet of the indoor wind channel;
an air inducing fan is disposed between the air inlet of the indoor wind channel and the air inducing pipe, the air inducing fan and the air inducing pipe are seal connected, and the air inducing fan and the air inlet of the indoor wind channel are also seal connected;
the air inlet of the indoor wind channel is disposed at a top of the air heat exchanging device, and an air outlet of the indoor wind channel is disposed at a lower part of the air heat exchanging device.

2. An integrated heat-exchanging air-conditioning device, comprising an upper flow divider, a heat exchanging core, and a lower flow divider, an air outlet of the upper flow divider and an air outlet of the lower flow divider being respectively connected to a fan, and an indoor wind channel and an outdoor wind channel separated from each other being disposed in the upper flow divider, the heat exchanging core and the lower flow divider respectively, wherein:
an air inducing pipe communicating with indoor heat generating equipment is disposed at an air inlet of the indoor wind channel, and an air conditioning evaporator is disposed at one side of the indoor wind channel near the air inducing pipe;
the air inducing pipe is constituted by a plurality of air inducing branch pipes disposed in parallel, and each air inducing branch pipe has one port disposed above the indoor heat generating equipment, and the other port disposed above the air inlet of the indoor wind channel or connected to the air inlet of the indoor wind channel;
an air inducing fan is disposed between the air inlet of the indoor wind channel and the air inducing pipe, the air inducing fan and the air inducing pipe are seal connected, and the air inducing fan and the air inlet of the indoor wind channel are also seal connected;
the air inlet of the indoor wind channel is disposed at a top of the integrated heat-exchanging air-conditioning device, and an air outlet of the indoor wind channel is disposed at a lower part of the integrated heat-exchanging air-conditioning device.

3. An air heat exchanging device, comprising an upper flow divider, a heat exchanging core, and a lower flow divider, an air outlet of the upper flow divider and an air outlet of the lower flow divider being respectively connected to a fan, and an indoor wind channel and an outdoor wind channel separated from each other being disposed in the upper flow divider, the heat exchanging core and the lower flow divider respectively, wherein:
an air inducing pipe communicating with indoor heat generating equipment is disposed at an air inlet of the indoor wind channel.

4. The air heat exchanging device according to claim 3, wherein:
one port of the air inducing pipe is disposed above the indoor heat generating equipment, and the other port of the air inducing pipe is disposed above the air inlet of the indoor wind channel or connected to the air inlet of the indoor wind channel.

5. The air heat exchanging device according to claim 3, wherein:
the air inducing pipe is constituted by a plurality of air inducing branch pipes disposed in parallel, and each air inducing branch pipe has one port disposed above the indoor heat generating equipment, and the other port disposed above the air inlet of the indoor wind channel or connected to the air inlet of the indoor wind channel.

6. The air heat exchanging device according to claim 3, wherein:
an air inducing fan is disposed between the air inlet of the indoor wind channel and the air inducing pipe.

7. The air heat exchanging device according to claim 6, wherein:
the air inducing fan and the air inducing pipe are seal connected, and the air inducing fan and the air inlet of the indoor wind channel are also seal connected.

8. The air heat exchanging device according to claim 3, wherein:
the air inlet of the indoor wind channel is disposed at a top of the air heat exchanging device, and an air outlet of the indoor wind channel is disposed at a lower part of the air heat exchanging device.

9. The air heat exchanging device according to any one of claims 3 to 8, wherein:
the air inducing pipe is a flame-retarded hose.

10. A manufacturing method of an air heat exchanging device, comprising:
mounting an air inducing pipe at an air inlet of an indoor wind channel of the air heat exchanging device; wherein
the air inducing pipe has one end disposed above the air inlet of the indoor wind channel, and the other end communicating with indoor heat generating equipment.

11. The manufacturing method of an air heat exchanging device according to claim 10, further comprising:
disposing an air inducing fan, wherein the air inducing fan is seal connected between the air inlet of the indoor wind channel and the air inducing pipe.

12. An integrated heat-exchanging air-conditioning device, comprising:
the air heat exchanging device according to any one of claims 3 to 9, wherein an air conditioning evaporator is disposed at one side of an indoor wind channel of the air heat exchanging device near the air inducing pipe.
